Europäisches Patentamt

European Patent Office

Office européen des brevets

(19)

(11) Numéro de publication: **0 165 826**

**A1**

(12) # DEMANDE DE BREVET EUROPEEN

(21) Numéro de dépôt: **85400786.1**

(51) Int. Cl.⁴: **H 01 L 21/306**

(22) Date de dépôt: **19.04.85**

(30) Priorité: **24.04.84 FR 8406378**

(43) Date de publication de la demande:
**27.12.85 Bulletin 85/52**

(84) Etats contractants désignés:
**DE GB IT NL**

(71) Demandeur: **THOMSON-CSF
173, Boulevard Haussmann
F-75379 Paris Cedex 08(FR)**

(72) Inventeur: **Velasco, Gonzalo
THOMSON-CSF SCPI 173, bld Haussmann
F-75379 Paris Cedex 08(FR)**

(72) Inventeur: **Nouailles, Noel
THOMSON-CSF SCPI 173, bld Haussmann
F-75379 Paris Cedex 08(FR)**

(72) Inventeur: **Pribat, Didier
THOMSON-CSF SCPI 173, bld Haussmann
F-75379 Paris Cedex 08(FR)**

(74) Mandataire: **Lepercque, Jean et al,
THOMSON-CSF SCPI 173, Bld Haussmann
F-75379 Paris Cedex 08(FR)**

(54) Procédé de gravure photoélectrochimique d'un matériau semi-conducteur.

(57) L'invention concerne un procédé de gravure photoélectrochimique par lequel on procède à l'immersion d'un matériau semi-conducteur dans une solution oxydante comprenant des éléments propres à dissoudre les oxydes qui se forment et l'exposition sélective à un rayonnement photonique photogénérateur de paires électron-trou (II).

Selon L'invention, on crée tout d'abord (1) des centres de recombinaison par implantation de particules chargées, électrons ou ions, de manière à limiter le parcours moyen de diffusion des paires électron-trou photogénérées pendant l'étape de gravure.

Application notamment à la fabrication de composants semi-conducteurs submicroniques.

**FIG. 2**

EP 0 165 826 A1

# PROCEDE DE GRAVURE PHOTOELECTROCHIMIQUE
## D'UN MATERIAU SEMICONDUCTEUR

La présente invention concerne un procédé de gravure photoélectrochimique d'un matériau semiconducteur.

De nombreuses publications et notamment l'article de PODLESNIK et autres paru dans la revue U.S. "Applied Physics Letters", volume 43, n° 12, 15 décembre 1983, pages 1083 - 1085 décrivent des procédés de gravure photochimique de matériaux semiconducteurs pour des applications telles que composants électro-optiques, composants microondes, etc.

L'article précité montre en particulier qu'il est possible d'obtenir en surface d'un matériau semiconducteur des réseaux optiques, notamment sur des substrats d'arséniure de gallium (Ga As).

Les méthodes mises en oeuvre consistent à générer, près de la surface du semiconducteur, à l'aide d'une irradiation par une source de lumière, des paires de porteurs électron-trou qui vont favoriser des réactions d'oxydation électrochimique de la surface, celle-ci étant mise en contact avec une solution oxydante qui, en outre, contient des éléments nécessaires à la dissolution de l'oxyde formé. ·

La source de lumière pour obtenir un réseau optique est naturellement une source cohérente, par exemple, dans l'exemple rappelé une source laser argon.

L'énergie reçue par le semiconducteur doit être suffisante pour obtenir la création des paires électron-trou mais inférieure à une énergie qui entraînerait un échauffement trop important du matériau et une dégradation de ses qualités cristallines.

De façon plus précise, pour obtenir un réseau, il est nécessaire de faire interférer deux ondes. Pour ce faire, on divise le faisceau émis par le laser en deux faisceaux. La surface d'un substrat semiconducteur plongée dans la solution oxydante reçoit directement d'une part, un des faisceaux divisés et, d'autre part, par exemple après réflexion, le deuxième faisceau. Ces deux faisceaux sont agencés de telle manière qu'ils interfèrent dans une région superficielle du substrat semiconducteur.

La gravure n'est pas limitée à un "type réseau". D'autres profils peuvent également être obtenus.

Cette méthode présente l'avantage de ne pas exiger l'utilisation de masque comme dans le cas des méthodes traditionnelles de lithographie. Elle autorise cependant les traitements localisés. Il suffit de n'exposer au rayonnement que les zones dans lesquelles on désire créer un relief de profil déterminé. Enfin, c'est une méthode basse-température.

Cependant, il a été constaté que ces méthodes ne pouvaient s'appliquer de façon satisfaisante que lorsque les reliefs désirés avaient des dimensions supérieures typiquement au micromètre.

En effet, si l'on définit la résolution spatiale du procédé de gravure par le rapport "profondeur/espacement" de sillons obtenus par ces méthodes, on constate que ce rapport diminue fortement pour des applications de type submicroniques, ce qui exclue de fait une large gamme d'applications potentielles.

Ces limitations peuvent s'expliquer par la longueur du parcours moyen de diffusion des porteurs photogénérés. En effet, lorsqu'on désire des profils de gravures dont les dimensions sont égales ou inférieures au micromètre, la longueur de ce parcours moyen est du même ordre de grandeur que les dimensions en question. On ne peut donc augmenter la résolution, telle qu'elle a été définie de façon significative. Les profils obtenus "s'adoucissent" lorsqu'on descend en dessous du micromètre.

L'invention se fixe pour but de pallier les insuffisances des procédés de gravure photoélectrochimiques de l'Art Connu en en améliorant la résolution spatiale.

Pour ce faire, le procédé de l'invention comprend, outre les étapes communes aux procédés de l'Art Connu, une étape supplémentaire initiale consistant en l'introduction maitrisée, dans les régions dans laquelle doivent être créés les gravures de profils déterminés, c'est-à-dire dans des régions superficielles, de centres de recombinaison électron-trou, ce afin de diminuer la longueur de diffusion des porteurs photogénérés.

Dans une variante du procédé, il peut être utile d'opérer de façon réversible, c'est-à-dire d'éliminer ces centres de recombinaison après obtention du relief désiré.

L'invention a donc pour objet un procédé de gravure photoélectrochimique d'une zone déterminée d'un substrat en matériau semiconducteur cristallin comprenant l'immersion du matériau cristallin dans une solution oxydante, cette solution comprenant en outre des éléments nécessaires à la dissolution d'oxydes du matériau semiconducteur et l'exposition sélective à un rayonnement photonique générateur de paires de porteurs électron-trou, caractérisé en ce qu'il comprend une étape préliminaire de création d'une densité prédéterminée de centres de recombinaison de paires de porteurs électron-trou dans une région superficielle du matériau semiconducteur couvrant tout ou partie de la dite zone déterminée.

L'invention sera mieux comprise et d'autres avantages et caractéristiques apparaîtront à l'aide de la description qui suit en référence aux figures annexées et parmi lesquelles :

- la figure 1 illustre un procédé de gravure photoélectrochimique selon l'Art Connu ;

- la figure 2 illustre le procédé selon l'invention.

Il est tout d'abord utile de rappeler de façon plus détaillée les principales étapes communes aux procédés de l'Art Connu.

Pour ce faire, sans que cela soit limitatif, on se placera dans ce qui suit dans le cadre de la formation d'un réseau optique dans une région superficielle d'un substrat en arséniure de gallium. La méthode opératoire est décrite de manière détaillée dans l'article précitée.

Le substrat est disposé dans un récipient contenant une solution oxydante qui en outre contient également des éléments nécessaires à la dissolution des oxydes qui vont se former.

Dans l'exemple choisi, la solution comprend de l'eau oxygénée et de l'acide sulfurique dilué dans de l'eau. La solution est du type $H_2O_2 : H_2SO_4 : H_2O$.

Il est indiqué que la solution offrant les meilleures performances obéissait aux proportions suivantes :

$H_2O_2 : H_2SO_4 : H_2O = 1 : 1 : 100.$

La source de lumière est une source laser argon dont on sélectionne une des raies émises : 514,5 ou 457,9 nm.

La puissance utilisée était 300 mW/cm$^2$. Elle est suffisante pour créer des paires électron-trou sans perturber l'organisation cristalline. Pour mémoire l'énergie, proportionnelle à la fréquence, obéit à la relation h $\nu$, dans laquelle h est la constante de PLANCK. D'autre part, la fréquence est donnée par la relation $\nu = c/\lambda$ où c est la vitesse de la lumière.

On en déduit une relation générale pour la longueur d'onde :

$\lambda < h (c/Eg)$ où Eg est l'énergie suffisante pour créer une paire électron-trou.

Pour l'arséniure de gallium, l'énergie doit être supérieure à 1,35 e.V.

Une mesure du profil de gravure obtenu était effectuée in-situ.

Le temps nécessaire pour obtenir la gravure était compris dans la gamme 2 à 6 mn.

Comme il a été indiqué, la résolution peut être caractérisée par le rapport profondeur/espacement des sillons du réseau optique obtenu.

Le tableau I disposé en fin de la présente description résume les résultats obtenus pour deux concentrations de la solution.

Cependant, comme il est indiqué dans ce qui suit, lorsqu'on désire des reliefs de dimensions submicroniques, en raison des phénomènes parasites de diffusion, les variations du relief deviennent de moins en moins abruptes quel que soit le temps d'attaque.

Il est aisé de constater que pour des espacements variant de 1 à 0,2 micromètre, le rapport (d/c), dans lequel d est la profondeur du sillon et e l'espacement moyen entre deux sillons, décroit très fortement.

Dans le cas de réseaux, la qualité de ceux-ci diminuent corrélativement et dans le cas plus général le relief obtenu ne peut présenter des variations de profils abruptes.

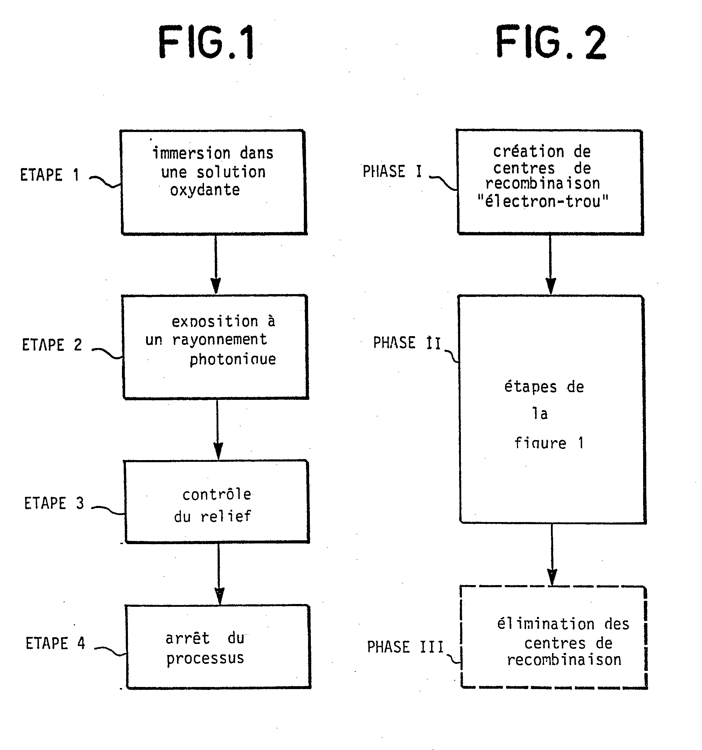

La figure 1 illustre les principales étapes communes aux procédés de l'Art Connu. Ces étapes peuvent se résumer en quatre étapes qui se chevauchent au moins partiellement :

- étape 1 : immersion dans une solution oxydante comprenant des éléments d'élimination des oxydes qui se forment.

- étape 2 : exposition à une irridiation photonique génératrice de paires électron-trou.

- étape 3 : Contrôle du relief obtenu.

- étape 4 : arrêt du processus lorsque le profil désiré de gravure est obtenu.

L'invention se fixe pour but de remédier aux insuffisances de l'Art Connu.

Tout en conservant les étapes des procédés de l'Art Connu, le procédé selon l'invention comprend une étape préliminaire supplémentaire consistant à introduire, de façon maitrisée, des centres de recombinaison électron-trou, dans une région superficielle du matériau semiconducteur. L'épaisseur de cette région doit être de l'ordre de grandeur ou supérieure à celle d'absorption de la lumière incidente.

L'effet de ces centres de recombinaison est de diminuer la longueur moyenne de diffusion des porteurs photogénérés. Ces centres restent donc confinés dans une région très proche du point de photogénération et de ce fait des variations abruptes de profil peuvent être obtenues, même dans le domaine submicronique. Il n'y a plus "écrasement du relief".

L'introduction de centres de recombinaison selon l'invention, s'effectue par irradiation à l'aide de particules chargées, électrons ou ions.

Selon une première variante d'exécution, le matériau va être soumis à un bombardement électronique à l'aide d'un accélérateur d'électrons classique. On a constaté expérimentalement que lorsqu'on soumet les atomes d'un réseau à un bombardement électronique, on crée, par échange d'énergie, des défauts. Les défauts se comportent comme des centres de recombinaison. Diverses hypothèses et explications ont été avancées quant aux mécanismes mis en jeu. Quoi qu'il en soit, l'expérience montre que ces phénomènes sont parfaitement reproductibles et que le nombre de défauts dépend de l'énergie et doses des électrons incidents.

Selon une seconde variante d'exécution, variante préférentielle, les centres vont être créés par implantation ionique.

Il est connu que l'on peut créer par implantation ionique une densité contrôlée de niveaux énergétiques dans la bande interdite d'un matériau semiconducteur qui agissent comme autant de centres recombinants.

Les paramètres de l'implantation doivent être choisis de façon à conserver la structure de bandes du semiconducteur nécessaire au mécanisme même de gravure photoélectrochimique.

La nature des ions implantés doit être choisie pour que les défauts créés deviennent électriquement inactifs ; si les propriétés électriques du semiconducteur doivent être conservées.

On peut alors procéder à une étape optionnelle après création du relief désiré, de régénération des qualités du réseau cristallin.

Cette étape peut consister en une étape de traitement thermique par recuit.

Les ions à implanter sont choisis de façon préférentielle parmi les gaz rares : hélium, néon, argon, krypton, xénon et radon ; c'est-à-dire parmi les éléments de la dernière colonne du tableau de la classification périodique des éléments.

Ces éléments, de par leurs propriétés chimiques et physiques n'entraînent que des perturbations réversibles dans le réseau cristallin.

Dans les applications pour lesquelles seules les caractéristiques purement géométriques de la surface sont exploitées, l'étape optionnelle de régénération est inutile. C'est le cas par exemple des réseaux optiques.

La figure 2 résume les phases du procédé selon l'invention.

Il comprend une première phase I, spécifique à l'invention de création de centres de recombinaisons et une deuxième phase II, commune à l'Art Connu.

Cette phase regroupe les étapes de la figure 1.

Enfin, il peut de façon optionnelle comprendre une troisième phase III, de régénération des qualités du réseau cristallin.

Pour fixer les idées, des exemples de réalisations de réseaux optiques sur un substrat en arséniure de gallium ont été réalisés dans des conditions analogues à celles de l'Art Connu, à l'exception naturellement de la phase spécifique à l'invention.

Les substrats cristallins en arséniure de gallium, d'orientation < 100 >, ont été dopés $\underline{n}$ dans une gamme comprise entre $10^{17}$ et $10^{19}$ atomes par $cm^3$. Ce dopage a été réalisé à l'aide de différents dopants classiques : silicium, tellure, etc... Les substrats avaient été polis de façon classique également par un traitement mécanochimique.

Selon la caractéristique spécifique à l'invention, il a été procédé à une implantation d'ions, en l'occurence d'ions de gaz néon. Les doses implantées étaient comprises dans la gamme 5 $10^{10}$ à $10^{13}$ atomes par $cm^3$ avec des énergies comprises entre 20 et 200 K.e.V.

Les substrats ont été immergés dans diverses solutions d'attaque, notamment une solution du type KOH : $H_2O$ dans les proportions relatives 1 : 100 à 1 : 500 et du type de celle décrite dans l'Art Connu $H_2O_2$ : $H_2SO_4$ : $H_2O$ dans les proportions relatives 1 : 1 : 100 à 1 : 1 : 1000.

Il a été créé des figures d'interférences en illuminant les substrats immergés par des faisceaux lasers de longueur d'onde $\lambda$ < 900 nm, et ce de manière à ce que l'énergie véhiculée soit supérieure à 1,35 C.V. puisque les substrats étaient en arséniure de gallium.

Le processus a induit dans les régions superficielles ainsi exposées une gravure inhomogène. La vitesse de gravure est fonc tion de la composition de la sélection, de l'intensité lumineuse locale qui dépend elle-même des figures d'interférence et de la dose d'implantation c'est-à-dire de la concentration des défauts agissant comme centre de recombinaison des paires "électron-trou". L'énergie associée aux ions détermine la profondeur moyenne de l'implantation.

Si l'on se reporte à nouveau au tableau I, dans le cas le plus défavorable, c'est-à-dire pour e = 0,2 micromètres, le rapport (d/e) n'est au mieux égal qu'à 0,03.

En faisant subir le traitement d'implantation propre à l'invention (figure 2, phase I), à des échantillons d'arséniure de gallium de même résistivité : dopage de l'ordre de $10^{18}$ atome par $cm^3$, on obtient pour des doses d'implantation ionique de $10^{11}/cm^2$ sous 200 K.e.V. un rapport (d/e) égal à 0,15, c'est-à-dire une résolution cinq fois supérieure à celle obtenue par le procédé de l'Art Connu.

Bien que l'invention trouve une application particulièrement intéressante pour les matériaux semiconducteur du type arséniure de gallium, qui est un matériau actuellement très utilisé pour la fabrication de nombreux composants électroniques ou optoélectroniques, elle n'est naturellement pas limitée à ce type de matériau. Tous autres matériaux semiconducteurs entrent dans son champ d'application, notamment le silicium.

Enfin, le traitement spécifique à l'invention, c'est-à-dire la première phase du procédé, peut s'effectuer de façon sélective.

On peut, par exemple, ne traiter qu'une partie de la surface d'un substrat. On obtient alors deux types de profils dans le relief créé par la gravure photoélectrochimique, selon que la région concernée a ou non subi le traitement propre à l'invention.

On peut également doser le nombre de centres de recombinaisons selon une loi de répartition spatiale définie. Le parcours moyen de diffusion est alors différent d'une zone à l'autre et l'efficacité du traitement propre à l'invention également différent d'une zone à l'autre.

## Tableau 1

| Espacement (micromètre) | $\frac{d}{e}$ (a) | $\frac{d}{e}$ (b) |
|---|---|---|
| 1 | 0.20 | 0.25 |
| 0.6 | 0.12 | 0.20 |
| 0.3 | 0.02 | 0.08 |
| 0.2 | 0.008 | 0.03 |

(a) Solution concentrée $H_2O_2$; $H_2SO_4$; $H_2O$ (1 : 1 : 25)

(b) Solution moins concentrée $H_2O_2$; $H_2SO_4$; $H_2O$ (1 : 1 : 100)

0165826

## REVENDICATIONS

1. Procédé de gravure photoélectrochimique d'une zone déterminée d'un substrat en matériau semiconducteur cristallin comprenant l'immersion (1) du matériau cristallin dans une solution oxydante, cette solution comprenant en outre des éléments nécessaires à la dissolution d'oxydes du matériau semiconducteur, et l'exposition (2) sélective à un rayonnement du matériau photonique générateur de paires de porteurs électron-trou, caractérisé en ce qu'il comprend une étape (I) préliminaire de création d'une densité prédéterminée de centres de recombinaison de paires de porteurs électron-trou dans une région superficielle du matériau semiconducteur couvrant tout ou partie de la dite zone déterminée.

2. Procédé selon la revendication 1, caractérisé en ce que ladite étape préliminaire (I) consiste en l'introduction dans le matériau semiconducteur de particules chargées.

3. Procédé selon la revendication 2, caractérisé en ce que lesdites particules sont des électrons et en ce que l'introduction est effectuée par bombardement électronique.

4. Procédé selon la revendication 2, caractérisé en ce que lesdites particules sont des ions et en ce que l'introduction est effectuée par implantation ionique.

5. Procédé selon la revendication 4, caractérisé en ce que les ions sont choisis parmi les gaz rares de la dernière colonne du tableau de classification périodique des éléments.

6. Procédé selon l'une quelconque des revendications 4 à 5, caractérisé en ce qu'il comprend en outre après gravure, une étape (III) ultérieure de traitement thermique par recuit de manière à éliminer lesdits ions implantés.

7. Procédé selon l'une quelconque des revendications 1 à 6, caractérisé en ce que le matériau semiconducteur cristallin est de l'arséniure de gallium.

# FIG.1

ETAPE 1 — immersion dans
une solution
oxydante

ETAPE 2 — exposition à
un rayonnement
photonique

ETAPE 3 — contrôle
du relief

ETAPE 4 — arrêt du
processus

# FIG.2

PHASE I — création de
centres de
recombinaison
"électron-trou"

PHASE II — étapes de
la
figure 1

PHASE III — élimination des
centres de
recombinaison

Office européen
des brevets

**RAPPORT DE RECHERCHE EUROPEENNE**

**0165826**
Numero de la demande

EP  85 40 0786

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int Cl.4) |
|---|---|---|---|
| X | APPLIED PHYSICS LETTERS, vol. 43, no. 5, septembre 1983, pages 488-489, American Institute of Physics, New York, US; K.C. LEE et al.: "A new method for the fabrication of submicron thick gallium arsenide membranes" * En entier * | 1,2,4-7 | H 01 L  21/306 |
| X | JOURNAL OF THE ELECTROCHEMICAL SOCIETY, vol. 122, no. 2, février 1975, pages 260-267, Princeton, US; A. YAMAMOTO et al.: "Anodic dissolution of N-type gallium arsenide under illumination" * Page 260, résumé; page 260, colonne 1, paragraphe 4 * | 1,2,4-7 | |
| A | APPLIED PHYSICS LETTERS, vol. 37, no. 3, août 1980, pages 316-318, American Institute of Physics, New York, US; H. FÖLL: "Anodic etching of RHO-type silicon as method for discriminating electrically active and inactive defects" * Page 316, résumé * | 1-6 | DOMAINES TECHNIQUES RECHERCHES (Int Cl.4)<br><br>H 01 L |

Le present rapport de recherche a été établi pour toutes les revendications

| Lieu de la recherche | Date d'achèvement de la recherche | Examinateur |
|---|---|---|
| LA HAYE | 26-08-1968 | VANCRAEYNEST F.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant